# EUROPÄISCHE PATENTANMELDUNG

(11) **EP 0 874 064 A1**
(43) Veröffentlichungstag der Anmeldung: **28.10.1998**
(21) Anmeldenummer: 98250074.6
(22) Anmeldetag: 27.02.1998
(51) Int. Cl.: C23C 14/02, C23C 14/06, C23C 14/58

(54) **Verfahren zur Oberflächenbehandlung von Werkzeugen aus Stahl**

(30) Priorität: 25.03.1997 DE 19714317
(71) Anmelder: MANNESMANN Aktiengesellschaft, 40213 Düsseldorf (DE)
(72) Erfinder: Henze, Werner, Dipl.-Ing., 40746 Langenfeld (DE); Häusler, Karl-Heinz, Ing., 41352 Korschenbroich (DE)
(74) Vertreter: Henze, Lothar

(57) **Zusammenfassung**

Die Erfindung betrifft ein Verfahren zur Oberflächenbehandlung von Werkzeugen aus Stahl, insbesondere von Kaltpilger-Walzdornen zur Kaltumformung von Rohren.
Die Erfindung ist dadurch gekennzeichnet, daß an der wirksamen Oberfläche des Werkzeuges eine Rauhigkeit nach DIN 4761-8.3 mit rundkämmigem Rauhigkeitsprofil ohne Aufwürfe an den Profilspitzen erzeugt wird, daß die so vorbereitete Oberfläche nach dem PVD-Verfahren auf CrN- Basis beschichtet wird und daß die aus diesem Beschichtungsprozeß resultierenden Wachstumsspieße auf der Werkzeugoberfläche weitgehend beseitigt werden.

## Beschreibung

Die Erfindung betrifft ein Verfahren zur Oberflächenbehandlung von Werkzeugen aus Stahl, insbesondere von Kaltpilger-Walzdornen zur Kaltumformung von Rohren.

Werkzeuge zum Kaltumformen von Rohren sind höchsten Belastungen ausgesetzt und müssen deshalb vor ihrem Einsatz so behandelt werden, so daß die Werkzeugoberflächen diesen Belastungen Stand halten. In der Zerspanungstechnik hat sich der Einsatz von Hartstoffschichten, wie sie nach der PVD-Technologie erzeugt werden, durchgesetzt. Bei dieser Technik, die Abkürzung PVD steht für Physical Vapour Deposition, werden metallische Werkstoffen durch physikalische Dampfabscheideprozesse mit Hilfe plasmaaktivierter Verfahren beschichtet. Dabei werden Hartstoffverbindungen mit hoher Verschleißbeständigkeit abgeschieden, wobei die Hartstoffverbindung im Fein- und Hochvakuumbereich aus den Ausgangselementen synthetisiert wird. Der metallische Anteil des Hartstoffes wird unmittelbar verdampft; eine Reaktion auf der zu beschichtenden Oberfläche führt zu der gewünschten Verbindung.

Während die PVD-Technologie in der Zerspanungstechnik weit verbreitet ist, ist sie in der Umformtechnik noch auf wenige Anwendungsfälle begrenzt.

Beim Kaltwalzen von Rohren konnte die den Werkzeugverschleiß mindernde PVD-Beschichtung bislang deshalb nicht erfolgreich eingesetzt werden, weil z.B. ein PVD-beschichteter Walzdorn wegen der Reibung im Rohr nicht einlauffähig ist. Im Unterschied dazu zeigt ein unbeschichteter Walzdorn bereits nach dem ersten Walzeinsatz eine walzpolierte Oberfläche.

Um das PVD-Verfahren auch für Werkzeuge zum Kaltumformen von Rohren anwendbar zu machen, insbesondere um die Reibung zwischen dem PVD beschichteten Walzdorn und dem Rohr zu verringern, mußten neue Wege beschritten werden. Davon ausgehend ist es die Aufgabe der vorliegenden Erfindung, einen Weg aufzuzeigen, wie eine wirksame PVD-Beschichtung auf die Rohrumformwerkzeuge aufgebracht werden kann, so daß deren Einsatz beim Herstellen von Rohren in wirtschaftlicher und technischer Weise ermöglicht wird.

Zur Lösung der Aufgabe wird erfindungsgemäß ein Verfahren vorgeschlagen, das dadurch gekennzeichnet ist, daß zunächst an der wirksamen Oberfläche des Werkzeuges eine Rauhigkeit nach DIN4761-8.3 mit rundkämmigem Rauhheitsprofil ohne Aufwürfe an den Profilspitzen erzeugt wird, daß die so vorbereitete Oberfläche nach dem PVD-Verfahren auf CrN-Basis beschichtet wird, und daß die aus diesem Beschichtungsprozeß resultierenden Wachstumsspitzen auf der Werkzeugoberfläche weitgehend beseitigt werden.

Der Erfindung liegt die Erkenntnis zugrunde, daß eine wirksame PVD-Beschichtung eines gattungsgemäßen Werkzeuges an verschiedene Voraussetzungen gebunden ist, nämlich an die Haftung der Schicht auf dem Werkzeug, an die Oberflächenrauhigkeit des Werkzeuges vor dem Beschichten und an die Oberflächenqualität des Werkzeuges nach dem Beschichten.

Die Haftung der Schicht auf dem Werkzeug setzt neben einer hohen Härte eine ausreichende Duktidität der Schicht sowie einen angenähert gleichen Temperatur-Ausdehnungskoeffizienten der Schicht zum Werkstoff des Werkzeuges voraus. Diese Kriterien werden von einer PVD-Schicht auf der Basis von CrN erfüllt.

Um die Einlauffähigkeit der PVD-beschichteten Werkzeuge in das Rohr, beispielsweise die Einlauffähigkeit des Kaltpilger-Walzdornes zu gewahrleisten, muß vor dem Beschichten des Werkzeuges eine definierte Oberflächenrauhigkeit eingestellt werden. Nach K. Keller und F. Koch "Beschichtete Umformwerkzeuge für Bleche", Bänder, Bleche, Rohre, 7 (1991), kann der Rohrwerkstoff mit steigender Belastung (Walzdruck) bei R_{Z} > 1,5 µm in die Rauhigkeitstäler der Werkzeugoberfläche gepreßt werden, was zu Mikroaufschweißungen führen kann. Bei R_{Z} < 0,25 µm kann bei hoher Belastung der Schmierfilm abgeschoben, d.h. versagen.

Erfindungsgemäß wird die Oberflächenqualität des Werkzeuges nach der Beschichtung durch die Oberflächentextur-Merkmale (DIN4761) des Werkzeuges vor der Beschichtung bestimmt. Vor der Beschichtung ist daher eine Werkzeugoberfläche mit einem rundkämmigen Profil nach DIN 4761-8.3 einzustellen. Nach dem Beschichten der Oberfläche mit einer PVD-Schicht auf CrN-Basis, d.h. vor dem Einsatz des Werkzeuges, sind die Wachstumsspieße auf der Werkzeugoberfläche, die aus dem Beschichtungsprozeß herrühren, zu beseitigen.

Um die erfindungsgemäßen Kriterien zu erfüllen, kann folgende Bearbeitungsfolge für ein Kalt-Walzwerk, insbesondere einen Kaltpilger-Walzdorn angewendet werden.

Zunächst wird das Werkzeug, beispielsweise der Dorn, durch Drehen auf einer Drehmaschine hergestellt, wonach die wirksame Oberfläche mit einem Schleifmittel der Körnung ≥ 400 geglättet wird. Im Anschluß daran erfolgt ein Abziehen der Oberfläche mit Schleifmittel der Körnung 900-1200. Durch elektrolytisches Polieren wird die Werkzeugoberfläche durch Abätzen im Säurebad weiter geglättet. Sodann erfolgt die Beschichtung des Werkzeuges mit CrN durch physikalische Dampfabscheidung mit Hilfe eines plasmaaktivierten Verfahrens (PVD-Verfahren). Zum Schluß wird die beschichtete Werkzeugoberfläche mit einer Diamantpaste der Körnung D1 bis D3 nach ISO R6109-80 abgezogen. Der letzte Bearbeitungsschritt mit einer Paste feinster Körnung beseitigt etwa noch vorhandene Wachstumsspieße auf der Werkzeugoberfläche, die während des Beschichtungsprozesses entstanden sind.

In einer Ausgestaltung des erfindungsgemäßen Verfahrens wird vorgeschlagen, zum Fertigschliff gemäß dem ersten Bearbeitungsschritt Siliciumcarbid oder Bornitrit zu verwenden.

Zum Abziehen der Oberfläche gemäß dem zweiten Bearbeitungsschritt werden nach einem weiteren Vorschlag der Erfindung Faservliese oder Faserbänder verwendet, die eine besonders einfache und gründliche Bearbeitung der Werkzeugoberfläche ermöglichen.

Durch das erfindungsgemäße Verfahren und die Bearbeitungsschritte wird es in vorteilhafter Weise ermöglicht, das in der Zerspanungstechnik bekannte PVD-Verfahren nunmehr auch für Werkzeuge zur Kaltumformung von Rohren, insbesondere zur Oberflächenbehandlung von Kaltpilger-Walzdornen anwendbar zu machen. Die Vorbereitung und Nachbehandlung des beschichteten Werkzeuges stellt die Eigenschaften her, die erforderlich sind, um ein PVD-beschichtetes Werkzeug zum Rohrwalzen einzusetzen. So sind insbesondere nach diesem Verfahren behandelte Kaltpilger-Walzdorne erfolgreich in Kaltpilger-Walzprozessen einsetzbar; denn diese Walzdorne zeigen sich besonders gut einlauffähig in das Rohr.

## Patentansprüche

1. Verfahren zur Oberflächenbehandlung von Werkzeugen aus Stahl, insbesondere von Kaltpilger-Walzdornen zur Kaltumformung von Rohren,
dadurch gekennzeichnet,
daß an der wirksamen Oberfläche des Werkzeuges eine Rauhigkeit nach DIN 4761-8.3 mit rundkämmigem Rauhigkeitsprofil ohne Aufwürfe an den Profilspitzen erzeugt wird, daß die so vorbereitete Oberfläche nach dem PVD-Verfahren auf CrN- Basis beschichtet wird und daß die aus diesem Beschichtungsprozeß resultierenden Wachstumsspieße auf der Werkzeugoberfläche weitgehend beseitigt werden.

2. Verfahren zur Oberflächenbehandlung nach Anspruch 1,
gekennzeichnet durch
die Abfolge folgender Bearbeitungsschritte:
a. Herstellung des Werkzeuges durch Drehen und Schleifen der wirksamen Oberfläche mit Schleifmitteln der Körnung ≧ 400,
b. Abziehen der Oberfläche mit Schleifmitteln der Körnung 900 bis 1200
c. Elektrolytisches Polieren der Werkzeugoberfläche,
d. Beschichtung des Werkzeuges mit CrN durch physikalische Dampfabscheidung mit Hilfe eines plasmaaktivierten Verfahrens (PVD-Verfahren)
e. Abziehen der beschichteten Werkzeugoberfläche mit Diamantpaste der Körnung D1 bis D3 nach ISO R6109-80.

3. Verfahren zur Oberflächenbehandlung von Werkzeugen aus Stahl nach Anspruch 2,
dadurch gekennzeichnet,
daß zum Fertigschliff gemäß Bearbeitungsschritt a. Siliciumcarbid oder Bornitrit Schleifbänder verwendet werden.

4. Verfahren zur Oberflächenbehandlung von Werkzeugen aus Stahl nach Anspruch 2,
dadurch gekennzeichnet,
daß zum Bearbeitungsschritt b. Faservliese oder -bänder verwendet werden.
